Europäisches Patentamt

European Patent Office

Office européen des brevets

(19)

(11) Veröffentlichungsnummer : **0 014 761**
**B1**

(12) **EUROPÄISCHE PATENTSCHRIFT**

(45) Veröffentlichungstag der Patentschrift :
**05.10.83**

(21) Anmeldenummer : **79105205.3**

(22) Anmeldetag : **17.12.79**

(51) Int. Cl.³ : **H 01 L 23/48, H 01 L 29/52**

(54) **Kontaktsystem für Leistungs-Thyristor.**

(30) Priorität : **20.01.79 DE 2902224**

(43) Veröffentlichungstag der Anmeldung :
**03.09.80 Patentblatt 80/18**

(45) Bekanntmachung des Hinweises auf die Patenterteilung : **05.10.83 Patentblatt 83/40**

(84) Benannte Vertragsstaaten :
**CH FR GB IT SE**

(56) Entgegenhaltungen :
**DE A 2 630 320**
**DE A 2 704 914**
**DE A 2 723 951**
**DE B 1 209 207**

(73) Patentinhaber : **BROWN, BOVERI & CIE Aktiengesellschaft Mannheim
Kallstadter Strasse 1
D-6800 Mannheim Käfertal (DE)**

(72) Erfinder : **Weimann, Klaus, Dipl.-Ing.
Wierdenstrasse 19
D-6840 Lampertheim (DE)**
Erfinder : **Eisele, Dieter, Dipl.-Phys.
Edisonstrasse 10
D-6840 Lampertheim (DE)**

(74) Vertreter : **Kempe, Wolfgang, Dr. et al
c/o Brown, Boveri & Cie AG Postfach 351
D-6800 Mannheim 1 (DE)**

Kontaktsystem für Leistungs-Thyristor

Die Erfindung bezieht sich auf ein Kontaktsystem für einen druckkontaktierbares Leistungs-Thyristor, welcher auf einem aktiven Siliziumblock Metallisierungen im Emitterbereich und im Gatebereich trägt, wobei zur Druckkontaktierung zunächst eine duktile Metallscheibe und darüber eine Kontaktplatte, welche beide je eine Bohrung zur isolierten Durchführung eines Steueranschlusses für ein Zentralgate besitzen, auf den Siliziumblock aufgesetzt sind. Leistungsthyristoren insbesondere solche für Frequenzanwendung, enthalten vielfach eine im Emitterbereich integrierte, verzweigte Gate-Struktur. Unter Leistungs-Thyristor wird dabei ein Bauelement mit einem Durchlaßstrom ≥ 10 Ampere verstanden.

Die Verzweigung der Gate-Struktur hat den Vorteil, daß die Einschaltverluste des Thyristors herabgesetzt und die Durchschaltzeiten verkürzt werden. Besonders letztere Forderung gilt in steigendem Maß auch für großflächige Leistungsthyristoren für Netzanwendung (50 Hz). Wegen der Druckkontaktierung solcher Systeme sind Maßnahmen erforderlich, die einen Kurzschluß zwischen der verzweigten Gate-Struktur und dem Emitterbereich verhindern.

Eine allgemein bekannte Maßnahme zur Vermeidung derartiger Kurzschlüsse besteht darin, die auf dem Halbleitermaterial aufgebrachte Metallschicht (Metallisierung) im Emitterbereich dicker als in der Gate-Struktur auszubilden. Dies bedingt nachteiligerweise einen schwierigen Herstellungs- bzw. Aufbringungsprozeß der Metallschicht. ·

Bei einer desweiteren allgemein bekannten Maßnahme wird vor Aufbringung der Metallschicht die Gate-Struktur mittels eines Ätzprozesses versenkt und danach Metallschichten in gleicher Dicke auf Emitterbereich und Gatestruktur aufgebracht. Als Nachteil ist hier der schwierige Ätzprozeß zu nennen (DE-B-1 209 207).

Gemäß einer weiteren allgemein bekannten Maßnahme werden Kurzschlüsse zwischen Emitterbereich und Gate-Struktur dadurch vermieden, daß in die zur Druckkontaktierung benötigte Kontaktplatte Vertiefungen entsprechend der Gate-Struktur eingearbeitet werden. Auch dies bedingt einen bei komplizierter Verzweigung der Gate-Struktur schwierigen Herstellungsprozeß (DE-B-1 209 207).

Der Erfindung liegt die Aufgabe zugrunde, ein Kontaktsystem für Leistungs-Halbleiterbauelemente mit verzweigter Gate-Struktur zu entwickeln, bei dem ein Kurzschluß zwischen der verzweigten Gate-Struktur und dem Emitterbereich verhindert wird, ohne daß zur Erzielung dieser Maßnahme aufwendige Herstellungsprozesse notwendig sind.

Diese Aufgabe wird erfindungsgemäß dadurch gelöst, daß der Gatebereich eine verzweigte Gate-Struktur besitzt, daß die duktile Metallscheibe zusätzlich Aussparungen entsprechend der Gate-Struktur besitzt, daß die Kontaktplatte eben ist und daß die justierte duktile Metallscheibe mittels eines elastischen Kunststoffes am umlaufenden Rand fixiert ist.

Die mit der Erfindung erzielbaren Vorteile bestehen insbesondere darin, daß die Metallschichten auf der Halbleiteroberfläche im Gate- und Emitterbereich gleich dick sein können und zudem auf gleichem Höhenniveau liegen. Desweiteren kann eine ebene Kontaktplatte Verwendung finden.

Vorzugsweise besteht die duktile Metallscheibe aus Silber und weist eine Dicke von 30 bis 500 μm auf.

Gemäß einer Ausbildung der Erfindung wird die duktile Metallscheibe nach erfolgter Justierung mittels eines elastischen Kunststoffes am umlaufenden Rand fixiert. Dadurch ist vorteilhafterweise kein Verdrehen oder Verschieben der justierten, duktilen Metallscheibe mehr möglich.

Desweiteren werden die Aussparungen der duktilen Metallscheibe durch Elektroerosion hergestellt. Durch Elektroerosion werden die Aussparungen völlig gratfrei erzeugt, was bei einem Druckkontaktsystem einen großen Vorteil darstellt.

Ein Ausführungsbeispiel der Erfindung ist im folgenden anhand der Zeichnungen erläutert.

Es zeigen :

Figur 1 ein Siliziumaktivteil eines großflächigen Leistungsthyristors mit verzweigter Gate-Struktur ;

Figuren 2, 3, 4 einen Schnitt durch das Siliziumaktivteil eines Leistungsthyristors längs der Linie AB bei bekannten Systemen ;

Figur 5 einen Schnitt durch das Siliziumaktivteil eines Leistungsthyristors längs der Linie AB beim erfindungsgemäßen System.

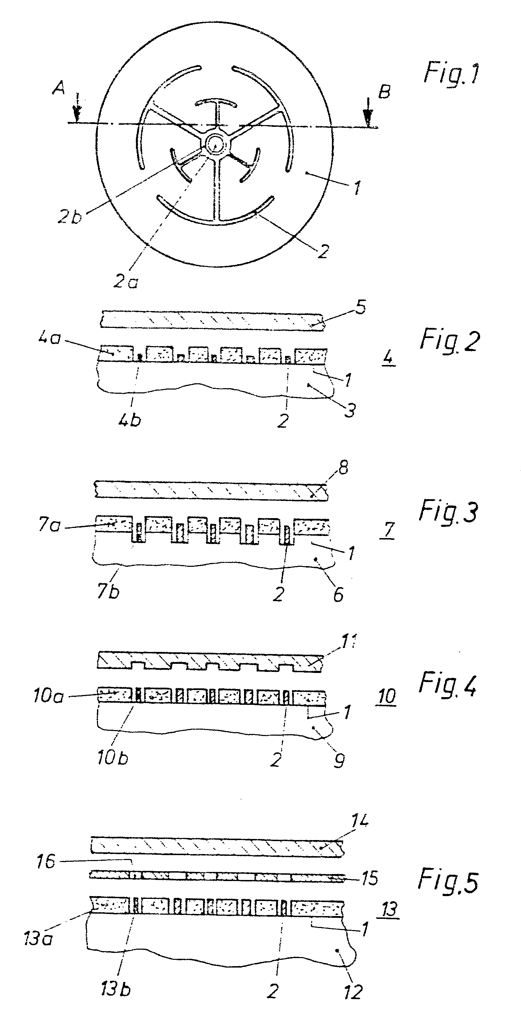

In Fig. 1 ist das Siliziumaktivteil eines großflächigen Leistungsthyristors dargestellt. Ein Emitterbereit 1 ist dabei von einer verzweigten, sternförmig aufgebauten Gate-Struktur 2 durchsetzt. Die Gate-Struktur 2 selbst weist im Zentrum des scheibenförmigen Siliziumaktivteiles ein Zentral-Gate 2a sowie ein ringförmig darum ausgebildetes Folgegate 2b auf. Das Folgegate 2b verzweigt sich sternförmig auf der Halbleiteroberfläche.

Zum besseren Verständnis des erfindungsgemäßen kontaktsystems sind in den Fig. 2, 3 und 4 zunächst die bereits erwähnten bekannten Systeme dargestellt. In Fig. 2 ist ein Schnitt durch das Siliziumaktivteil eines Leistungsthyristors gemäß Fig. 1 längs der Linie AB dargestellt. Ein Siliziumblock 3 mit Emitterbereich 1 und Gate-Struktur 2 ist dabei von einer Metallisierung 4 bedeckt und zwar überdeckt die Metallisierung 4a den Emitterbereich 1 und die Metallisierung 4b die Gate-Struktur 2. Die Metallisierung 4 auf dem Siliziumblock 3 ist im Gatebereich 2 dünner als im Emitterbereich 1. Auf die Metallisierung 4 wird eine zur Druckkontaktierung benötigte Kontaktplatte 5 aufgesetzt.

In Fig. 3 weist ein Siliziumblock 6 eine durch einen Ätzprozeß versenkte Gate-Struktur 2 und einen im Vergleich hierzu erhöhten Emitterbereich 1 auf. Die Metallisierung 7, bestehend aus der Metallisierung 7a auf dem Emitterbereich 1 und der Metallisierung 7b auf dem Gatebereich 2, weist gleiche Dicken auf.

Gemäß Fig. 4 ist die auf einem Siliziumblock 9 aufgebrachte Metallisierung 10 in beiden Bereichen, auf Emitterbereich 1 (Metallisierung 10a) und auf der Gate-Struktur 2 (Metallisierung 10b) gleich dick. Die aufliegende Kontakplatte 11 hat jedoch im Gatebereich Aussparungen entsprechend der Gate-Struktur 2.

In Fig. 5 ist in Verbindung mit Fig. 1 das eigentliche Ausführungsbeispiel der Erfindung dargestellt. Ein Siliziumblock 12 weist sowohl in seinem Emitterbereich 1 als auch in seinem Gatebereich 2 Metallisierungen 13 (Metallisierung 13a im Emitterbereich 1 und Metallisierung 13b im Gatebereich 2) von gleicher Dicke auf.

Eine zur Druckkontaktierung aufgesetzte Kontaktplatte 14 ist eben und weist lediglich in ihrem Zentrum eine Bohrung zur isolierten Durchführung des Steueranschlusses für das Zentralgate 2a auf. Die Kontaktplatte 14 besteht vorzugsweise aus Molybdän. Ihr liegt im Normalfall ein hier nicht dargestellter Druckkontaktkörper aus Rupfer an. Zwischen der Kontaktplatte 14 und der Metallisierung 13 liegt eine duktile Metallscheibe 15, die Aussparungen 16 entsprechend der geometrischen Struktur des Gatebereichs 2 aufweist. Diese duktile Metallscheibe 15 besteht vorzugsweise aus Silber und ist vorzugsweise zwischen 30 und 500 μm dick.

Die der Form des Gatebereichs 2 entsprechenden Aussparungen 16 der Metallscheibe 15 werden durch Elektroerosion, Stanzen oder auch Ätzen eingeformt. Nach Auflegen der Metallscheibe 15 auf die Oberfläche des metallbeschichteten Siliziumblocks 12 erfolgt eine Justierung der Scheibe 15 entsprechend der Gate-Geometrie. Um einem Verdrehen oder Verschieben der Metallscheibe 15 entgegenzuwirken, wird die Scheibe 15 mittels eines elastischen Kunststoffes am Umfang fixiert. Danach wird die ebene Kontaktplatte aufgedrückt.

Die so ausgerüsteten Leistungs-Thyristoren eignen sich beispielsweise zur Anwendung als Frequenzthyristoren oder auch für Hochspannungs Gleichstrom-Übertragungsanlagen (HGÜ).

block (12) und Kontaktplatte (14) eine duktile Metallscheibe (15) mit Durchbrechungen (16) entsprechend der Gate-Struktur und einer Bohrung zur Durchführung des Steueranschlusses für das Zentralgate (2a) eingefügt ist, und daß die justierte duktile Metallscheibe (15) mittels eines elastischen Kunststoffes am umlaufenden Rand fixiert ist.

2. Kontaktsystem nach Anspruch 1, dadurch gekennzeichnet, daß die Aussparungen (16) der duktilen Metallscheibe (15) durch Elektroerosion hergestellt werden.

3. Kontaktsystem nach Anspruch 1 oder 2, dadurch gekennzeichnet, daß die duktile Metallscheibe (15) aus Silber besteht.

4. Kontaktsystem nach Anspruch 1, 2 oder 3, dadurch gekennzeichnet, daß die duktile Metallscheibe (15) eine Dicke von 30 bis 500 μm aufweist.

**Claims**

1. Contact system for a pressure-contactable power thyristor, which bears a branched gate structure and metallizations (13a, 13b) on an active silicon block (12) in the emitter region (1) and in the gate region (2), wherein a contact plate (14), which comprises a flat underside and a bore for the insulated passage of a control connection for a central gate (2a), is mounted on the silicon block (12) for the purpose of pressure-contacting, characterised in that a ductile metal disc (15) with openings (16) corresponding to the gate structure and a bore for the passage of the control connection for the central gate (2a) is inserted between the silicon block (12) and the contact plate (14), and that the positioned ductile metal disc (15) is fixed by means of a resilient plastics material at the surrounding edge.

2. Contact system according to claim 1, characterised in that the recesses (16) of the ductile metal disc (15) are produced by means of electroerosion.

3. Contact system according to claim 1 or 2, characterised in that the ductile metal disc (15) consists of silver.

4. Contact system according to claim 1, 2 or 3, characterised in that the ductile metal disc (15) has a thickness of between 30 and 500 μm.

**Ansprüche**

1. Kontaktsystem für einen druckkontaktierbaren Leistungs-Thyristor, welcher auf einem aktiven Siliziumblock (12) eine verzweigte Gate-struktur und Metallisierungen (13a, 13b) im Emitterbereich (1) und im Gatebereich (2) trägt, wobei zur Druckkontaktierung eine Kontaktplatte (14), welche eine flache Unterseite und eine Bohrung zur isolierten Durchführung eines Steueranschlusses für ein Zentralgate (2a) besitzt, auf den Siliziumblock (12) aufgesetzt sind, dadurch gekennzeichnet, daß zwischen Silizium-

**Revendications**

1. Système de contact destiné à un thyristor de puissance qu'on peut mettre en contact par pression, et qui porte sur un bloc de silicium actif (12) une structure de gâchette ramifiée et des métallisations (13a, 13b) dans la zone d'émetteur (1) et dans la zone de gâchette (2), tandis que pour le contact par pression on place sur le bloc de silicium (12) une plaque de contact (14) qui comporte un côté inférieur plat et un alésage pour la traversée isolée d'un raccordement de commande destiné à une gâchette centrale (2a), caractérisé en ce que, entre le bloc de silicium (12) et la plaque de contact (14), on introduit un disque métallique ductile (15) ayant des découpures (16) en fonction de la structure de gâchette et un alésage pour le passage du raccordement de commande destiné à la gâchette centrale (2a), et en ce que le disque métallique ductile ajusté (15) est fixé au bord périphérique au moyen d'une matière plastique élastique.

2. Système de contact selon la revendication 1, caractérisé en ce que les évidements (16) du disque métallique ductile (15) sont réalisés par électroérosion.

3. Système de contact selon la revendication 1 ou 2, caractérisé en ce que le disque métallique ductile (15) est en argent.

4. Système de contact selon la revendication 1, 2 ou 3, caractérisé en ce que le disque métallique ductile (15) présente une épaisseur de 30 à 500 µm.

Fig.1

Fig.2

Fig.3

Fig.4

Fig.5